# EUROPEAN PATENT APPLICATION

(11) **EP 3 159 428 A1**
(43) Date of publication of application: **26.04.2017**
(21) Application number: 15809725.3
(22) Date of filing: 11.06.2015
(51) Int. Cl.: C23C 14/06, C01G 25/00, C01G 55/00, C23C 14/34, H01L 41/316, H01L 41/319

(54) **MULTILAYER FILM AND METHOD FOR MANUFACTURING SAME**

(30) Priority: 20.06.2014 JP 2014127468
(71) Applicant: ULVAC, Inc., Chigasaki-shi, Kanagawa 253-8543 (JP)
(72) Inventor: KOBAYASHI Hiroki, Chigasaki-shi Kanagawa 253-8543 (JP); HENMI Mitsunori, Chigasaki-shi Kanagawa 253-8543 (JP); HIROSE Mitsutaka, Chigasaki-shi Kanagawa 253-8543 (JP); TSUKAGOSHI Kazuya, Chigasaki-shi Kanagawa 253-8543 (JP); KIMURA Isao, Chigasaki-shi Kanagawa 253-8543 (JP); SUU Koukou, Chigasaki-shi Kanagawa 253-8543 (JP)
(74) Representative: Zacco GmbH
(86) International application number: PCT/JP2015/066926
(87) International publication number: WO 2015/194458

(57) **Abstract**

A method of manufacturing a multi-layered film at least includes: a step A of forming an electroconductive layer on a substrate; a step B of forming a seed layer so as to coat the electroconductive layer; and a step C of forming a dielectric layer so as to coat the seed layer. In the step B, a compound including strontium (Sr), ruthenium (Ru), and oxygen (O) is formed as the seed layer by a sputtering method. In the step C, where a substrate temperature is defined by Td when the dielectric layer is formed, 560°C≤Td≤720°C is determined.

## Description

### TECHNICAL FIELD

The present invention relates to a method of manufacturing a multi-layered film including a dielectric layer having a high degree of crystallinity and relates to the multi-layered film.

This application claims priority from Japanese Patent Application No. 2014-127468 filed on June 20, 2014, the contents of which are incorporated herein by reference in their entirety.

### BACKGROUND ART

Currently, a piezo element using a ferroelectric material such as lead zirconate titanate (Pb(Zr, Ti)O₃: PZT) is applied to an MEMS (Micro Electro Mechanical Systems) technique such as an inkjet head an acceleration sensor.

Particularly, a PZT film has been attracted attention and actively researched by various organizations (Patent Document 1 to 3).

Various research has been conducted in order to improve withstand voltage characteristics of a PZT film.

In the case of forming a PZT film by a sputtering method, since the film is not sufficiently crystallized when the film formation is completed, there is a need to carry out a heat treatment in order for crystallization after film formation.

Generally, this heat treatment is referred to as a post- heat treatment or an annealing treatment.

The crystal of the PZT film includes not only a perovskite phase having requested piezoelectricity but also a pyrochlore phase that is a quasi-stable phase and does not have piezoelectricity.

Conventionally, a crystal including a pyrochlore phase is easily obtained, but it is extremely difficult to obtain a dielectric film that does not include a pyrochlore phase but has a high degree of crystallinity.

Consequently, in order to improve the withstand voltage characteristics, the development of the method has been expected which stably forms a multi-layered film provided with the dielectric film that does not include a pyrochlore phase but has a high degree of crystallinity.

### PRIOR ART DOCUMENTS

### PATENT DOCUMENTS

[Patent Document 1] Japanese Unexamined Patent Application, First Publication No. 2007-327106
[Patent Document 2] Japanese Unexamined Patent Application, First Publication No. 2010-084180
[Patent Document 3] Japanese Unexamined Patent Application, First Publication No. 2003-081694

### SUMMARY OF INVENTION

### PROBLEMS TO BE SOLVED BY THE INVENTION

The invention was made in view of the above-described conventional situations, and has a first object to provide a method of manufacturing a multi-layered film provided with a dielectric layer that does not include a pyrochlore phase but has a high degree of crystall in ity.

Furthermore, the invention has a second object to provide a multi-layered film provided with a dielectric layer that does not include a pyrochlore phase but has a high degree of crystallinity.

### MEANS FOR SOLVING THE PROBLEMS

According to a first aspect of the invention, a method of manufacturing a multi-layered film, includes: forming an electroconductive layer on a substrate (step A); forming a seed layer by compound including strontium (Sr), ruthenium (Ru), and oxygen (O) so as to coat the electroconductive layer by a sputtering method (step B); and forming a dielectric layer so as to coat the seed layer (step C) so that, where a substrate temperature is defined by Td (dielectric) when the dielectric layer is formed, 560°C≤Td≤720°C is satisfied.

In the above-described method of manufacturing a multi-layered film of the first aspect, according to the second aspect of the invention, when the dielectric layer is formed, a compound including lead (Pb), zirconia (Zr), titanium (Ti), and oxygen (O) may be formed as the dielectric layer by a sputtering method.

According to a third aspect of the invention, a multi-layered film includes an electroconductive layer made of platinum (Pt), a seed layer, and a dielectric layer, which are at least sequentially disposed on a main surface of a substrate made of silicon, wherein the seed layer is made of a compound including strontium (Sr), ruthenium (Ru), and oxygen (O), the dielectric layer is made of a compound including lead (Pb), zirconia (Zr), titanium (Ti), and oxygen (O), and the compound that forms the dielectric layer does not have an X-ray diffraction peak due to a pyrochlore phase.

In the above-described multi-layered film of the third aspect, according to the fourth aspect of the invention, in the compound that forms the dielectric layer, a half-value width (FWHM) of an X-ray diffraction peak due to (100) of Pb(Zr, Ti)O₃ may be less than or equal to 1 degree.

### Effects of the Invention

In the method of manufacturing a multi-layered film according to each of the aforementioned aspects, the compound including strontium (Sr), ruthenium (Ru), and oxygen (O) is formed as the seed layer by a sputtering method in the step B, the substrate temperature Td (dielectric) is in the range of 560°C to 720°C when the dielectric layer is formed in the step C, and therefore the dielectric film formed on the seed layer has a high degree of crystallinity.

Particularly, from the compound that forms the dielectric layer, an X-ray diffraction peak due to a perovskite phase is observed, but an X-ray diffraction peak due to a pyrochlore phase is not observed.

Accordingly, the invention can provide a method of manufacturing a multi-layered film provided with a dielectric layer that does not include a pyrochlore phase but has a high degree of crystallinity.

Additionally, in the multi-layered film according to each of the aforementioned aspects, the dielectric layer is made of a compound including lead (Pb), zirconia (Zr), titanium (Ti), and oxygen (O), and the compound that forms the dielectric layer does not include an X-ray diffraction peak due to a pyrochlore phase.

Therefore, according to the invention, it is possible to provide a multi-layered film including the dielectric layer having a high degree of crystallinity.

Such multi-layered film has excellent characteristics such as having both high piezoelectricity and high voltage resistance.

### BRIEF DESCRIPTION OF THE DRAWINGS

FIG. 1 is a cross-sectional view showing one configuration example of a multi-layered film according to one embodiment of the invention.
FIG. 2A is a diagram schematically showing the size of a crystallite and the shape of an X-ray diffraction peak.
FIG. 2B is a diagram schematically showing the size of a crystallite and the shape of an X-ray diffraction peak.
FIG. 3A is a cross-sectional view showing a process of manufacturing the multi-layered film according to the embodiment.
FIG. 3B is a cross-sectional view showing a process of manufacturing the multi-layered film according to the embodiment.
FIG. 3C is a cross-sectional view showing a process of manufacturing the multi-layered film according to the embodiment.
FIG. 4 is a view schematically showing an internal constitution of a film formation apparatus used in the embodiment.
FIG. 5 is a chart showing the diffraction peak which indicates the crystal structure of the PZT film formed by Sample 1.
FIG. 6 is a chart showing the diffraction peaks which indicate the crystal structure of the PZT films of Samples 2 to 4.
FIG. 7 is a chart showing the relationship between a substrate temperature and peak intensity due to a pyrochlore phase.
FIG. 8 is a chart showing crystallinities of the PZT films of Samples 1 and 3.

### EMBODIMENTS FOR CARRYING OUT THE INVENTION

Hereinafter, a multi-layered according to one embodiment of the invention will be described with reference to drawings.

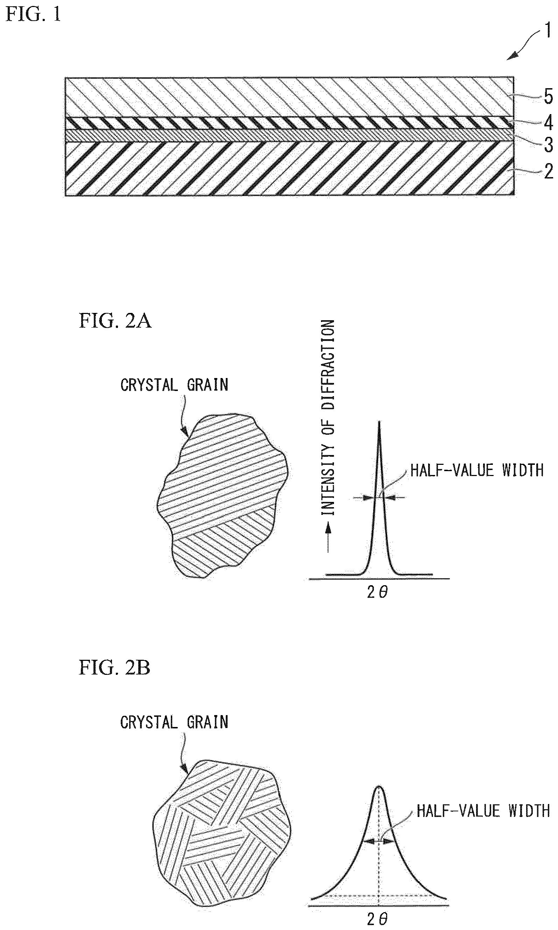

FIG. 1 is a cross-sectional view showing one configuration example of a multi-layered film according to the embodiment.

The multi-layered film 1 includes an electroconductive layer 3 made of platinum (Pt), a seed layer 4, and a dielectric layer 5 which are at least sequentially disposed on a main surface of a substrate 2 made of silicon.

The seed layer 4 is made of a compound including strontium (Sr), ruthenium (Ru), and oxygen (O).

As the seed layer 4, for example, SrRuO₃ (SRO) is adopted.

The dielectric layer 5 is disposed on the above-mentioned seed layer 4 including strontium (Sr), ruthenium (Ru), and oxygen (O).

The dielectric layer 5 is not particularly limited, but is made of a ferroelectric material such as lead zirconate titanate (Pb(ZrₓTi₁₋ₓ)O₃: PZT), PbTiO₃, BaTiO₃, PMM-PZT, PNN-PZT, PMN-PZT, PNN-PT, PLZT, PZTN, NBT, and KNN

Particularly, in the multi-layered film 1 according to the embodiment, a compound forming a dielectric layer has a high degree of crystallinity.

Specifically, since a peak due to a pyrochlore phase is not observed from the compound that forms the dielectric layer by an X-ray diffraction method, the compound does not include a pyrochlore phase.

Since the seed layer 4 has, for example, a perovskite structure, the dielectric layer 5 disposed on the seed layer 4 has a perovskite structure which does not include a different phase.

Consequently, the multi-layered film 1 has excellent characteristics such as high piezoelectricity and high voltage resistance.

The above-described multi-layered film 1 is preferably used in, for example, a piezo element or the like.

Moreover, in the compound forming the dielectric layer 5, the half-value width (full width at half maximum: FWHM) of the X-ray diffraction peak which is caused by Pb(ZrₓTi₁₋ₓ)O₃ (100) is less than or equal to 1 degree.

Here, according to P. Scherrer (Kazuhiko Kandori, "Study of solid-state structure by powder X-ray diffraction measurement", online, searched on the Internet on March 10, 2014 (URL: http://www.osaka-kyoiku.ac.jp/~rck/kandori.pdf), where the size of a crystallite (crystallite diameter) is represented as L and where the broadening at the position corresponding to a half of the peak intensity is represented as 20 (half-value width, β), the relationship of "L=Kλ/(βcosθ)" is obtained.

FIGS. 2A and 2B are diagrams schematically showing the size of a crystallite and the shape of an X-ray diffraction peak.

As shown in FIG. 2A, in the case where a crystallite grows well, a half-value width is narrow, and a peak having a sharp shape is observed.

In contrast, as shown in FIG. 2B, in the case where a crystallite is small, a half-value width is widened, and a peak having a dull shape is observed.

According to the above evaluation method, it is apparent that, in the compound forming the dielectric layer 5 which constitutes the multi-layered film according to the embodiment and in which the aforementioned half-value width of 1 degree or less is observed, the crystallite is largely grown and has an extremely high degree of crystallinity.

As a result of adopting the method of manufacturing a multi-layered film according to the embodiment which will be described later, the dielectric film formed on the seed layer 4 including strontium (Sr), ruthenium (Ru), and oxygen (O) does not include a pyrochlore phase but has a high degree of crystallinity.

The multi-layered film 1 has excellent characteristics such as high piezoelectricity and high voltage resistance.

The above-described multi-layered film 1 is preferably used in, for example, a piezo element or the like.

Hereinbelow, a method of manufacturing the multi-layered film according to the embodiment will be described.

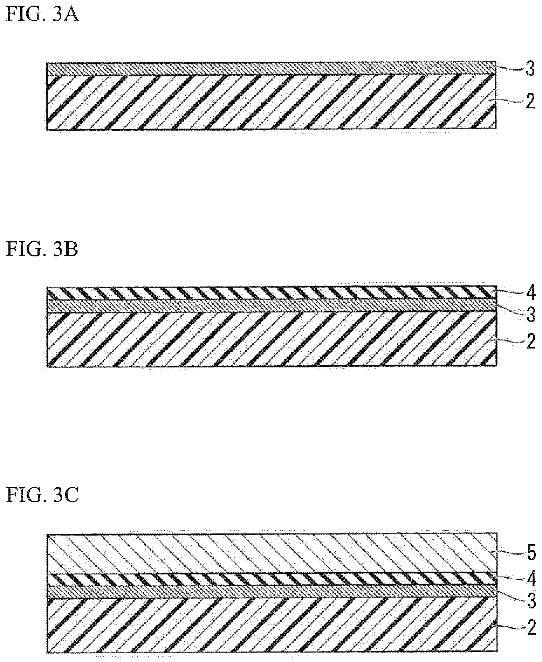

FIGS. 3A to 3C are cross-sectional views schematically showing steps of manufacturing the multi-layered film according to the embodiment.

The method of manufacturing a multi-layered film according to the embodiment is the manufacturing method of the multi-layered film 1 that at least includes: a step A of forming the electroconductive layer 3 on the substrate 2 (FIG. 3A); a step B of forming the seed layer 4 so as to coat the electroconductive layer 3 (FIG. 3B); and a step C of forming the dielectric layer 5 so as to coat the seed layer 4 (FIG. 3C). In the step B, the compound including strontium (Sr), ruthenium (Ru), and oxygen (O) is formed as the seed layer by a sputtering method. In the step C, where a substrate temperature is Td (dielectric) when the dielectric layer is formed, 560°C≤Td≤720°C is determined.

In the method of manufacturing the multi-layered film according to the embodiment, the compound including strontium (Sr), ruthenium (Ru), and oxygen (O) is formed as the seed layer by a sputtering method in the step B, 560°C≤Td≤720°C is determined in the step C where a substrate temperature is Td (dielectric) when the dielectric layer is formed.

Consequently, the dielectric film formed on the seed layer does not include a pyrochlore phase but has a high degree of crystallinity.

Such multi-layered film has excellent characteristics such as high piezoelectricity and high voltage resistance.

In the following explanation, as an example, the case will be described where lead zirconate titanate (Pb(ZrₓTi₁₋ₓ)O₃: PZT) is used as the dielectric layer 5; however, the invention is not limited to this.

### (Film Formation Apparatus)

Hereinbelow, the configuration of a preferred film formation apparatus in order to carry out the method of manufacturing a multi-layered film according to the embodiment will be described.

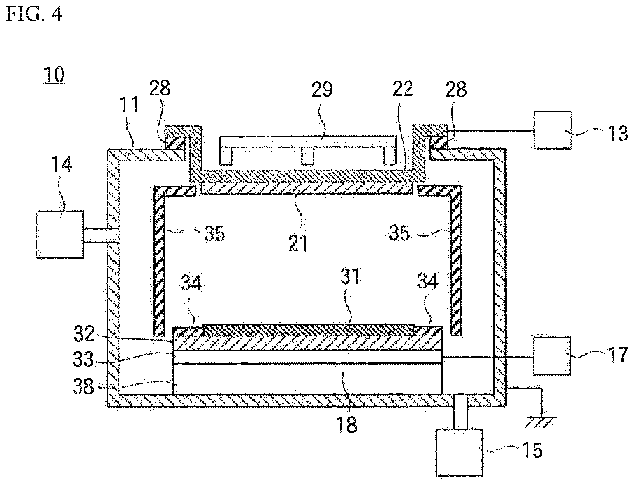

FIG. 4 is a schematic cross-sectional view showing an example of the internal constitution of a film formation apparatus 10.

The film formation apparatus 10 includes: a vacuum chamber 11; a target 21; a support (substrate holding stage) 32; a temperature controller 18; a sputtering power source 13; a sputtering gas introduction unit 14; a first adhesion-preventing plate 34; and a second adhesion-preventing plate 35.

The target 21 is disposed in the vacuum chamber 11.

The support 32 is disposed at the position facing to the target 21 and is configured to hold a substrate 31 (substrate 2).

The temperature controller 18 controls a substrate temperature by heating or cooling the substrate 31 supported by the support 32.

The sputtering power source 13 is configured to apply a voltage to the target 21.

The sputtering gas introduction unit 14 is configured to introduce a sputtering gas into the vacuum chamber 11.

The first adhesion-preventing plate 34 and the second adhesion-preventing plate 35 are disposed in the vacuum chamber 11 at the positions to which particles emitted from the target 21 are attached.

A cathode electrode 22 is disposed at the upper wall surface of the vacuum chamber 11 with an insulating member 28 interposed therebetween, and the cathode electrode 22 is electrically insulated from the vacuum chamber 11.

The vacuum chamber 11 has a ground potential.

One of the surfaces of the cathode electrode 22 is locally exposed to the inside of the vacuum chamber 11.

The target 21 is brought into close contact with and fixed to the center portion of the exposed region of the surface of the cathode electrode 22, and the target 21 is electrically connected to the cathode electrode 22.

The sputtering power source 13 is disposed outside the vacuum chamber 11.

The sputtering power source 13 is electrically connected to the cathode electrode 22 and is capable of applying an alternating voltage to the target 21 through the cathode electrode 22.

A magnet device 29 is disposed on the cathode electrode 22 on the opposite side of the target 21, that is, on the other side of the cathode electrode 22.

The magnet device 29 is configured to form magnetic field lines on the surface of the target 21.

The support 32 on which the substrate 31 is to be mounted is made of, for example, carburization silicon (SiC).

The outer-periphery of the support 32 is formed larger than the outer-periphery of the substrate 31.

The surface of the support 32 is arranged so as to face the surface of the target 21.

The means which electrostatically attracts the substrate 31 is located inside the support 32.

When the substrate 31 is electrostatically attracted to the center region of the surface of the support 32, the back surface of the substrate 31 is brought into close contact with the center region of the surface of the support 32, and the substrate 31 is thermally connected to the support 32.

The first adhesion-preventing plate 34 is made of quartz or ceramics such as alumina.

The first adhesion-preventing plate 34 is formed in an annular shape such that the inner-periphery of the first adhesion-preventing plate 34 is larger than the outer-periphery of the substrate 31 and the first adhesion-preventing plate is arranged so as to cover the outer-edge portion which is the outside of the center region of the surface of the support 32.

Consequently, the particles discharged from the target 21 are prevented from being adhered to the outer-edge portion of the surface of the support 32.

The back surface of the first adhesion-preventing plate 34 is brought into close contact with the outer-edge portion of the surface of the support 32, and the first adhesion-preventing plate 34 is thermally connected to the support 32.

When the substrate 31 is mounted on the center region of the surface of the support 32, the first adhesion-preventing plate 34 is arranged so as to surround the outer side of the outer-periphery of the substrate 31.

The second adhesion-preventing plate 35 is made of quartz or ceramics such as alumina.

The second adhesion-preventing plate 35 is formed in a cylindrical shape such that the inner-periphery of the second adhesion-preventing plate 35 is larger than the outer-periphery of the target 21 or the outer-periphery of the substrate 31.

The second adhesion-preventing plate 35 is arranged between the support 32 and the cathode electrode 22 and is configured to surround the side region of the space between the substrate 31 and the target 21.

For this reason, the particles discharged from the target 21 are prevented from being adhered to the wall surface of the vacuum chamber 11.

The temperature controller 18 includes a heat generation member 33 and a heating power source 17.

As a material used to form the heat generation member 33, SiC is used.

The heat generation member 33 is placed at the position on the opposite side of the substrate 31 with the support 32 interposed therebetween.

The heating power source 17 is electrically connected to the heat generation member 33.

When a direct current is supplied to the heat generation member 33 from the heating power source 17, the heat generated from the heat generation member 33 is transmitted through the support 32 to the substrate 31 mounted on the support 32 and the first adhesion-preventing plate 34.

Therefore, the substrate 31 and the first adhesion-preventing plate 34 are thereby heated together.

The back surface of the substrate 31 is in close contact with the center region of the surface of the support 32, the heat is uniformly transferred to the center portion of the substrate 31 and the outer-edge portion.

A cooling unit 38 is disposed on the heat generation member 33 on the opposite side of the support 32.

The cooling unit 38 is configured to be able to circulate a temperature-controlled cooling medium in the internal side thereof and prevents the wall surface of the vacuum chamber 11 from being heated even where heat is generated from the heat generation member 33.

The sputtering gas introduction unit 14 is connected to the inside of the vacuum chamber 11 and is configured to be able to introduce a sputtering gas into the inside of the vacuum chamber 11.

### (Method of Forming Multi-layered Film)

Hereinbelow, a method of forming a multi-layered film will be described.

FIGS. 3A to 3C are cross-sectional views showing steps of manufacturing the multi-layered film according to the embodiment.

When such manufacturing processes are carried out, the aforementioned film formation apparatus shown in FIG. 4 is used.

FIG. 4 shows an example of the case where the film formation apparatus 10 includes one vacuum chamber 11 in order to simplify the explanation thereof; however, in the manufacturing method including the steps A to C which will be described below, the case is explained where the film formation apparatus that is configured to include at least three vacuum chambers 11a, 11b, and 11c (11) is used. The vacuum chambers are communicated with each other via an isolation valve which is not shown in the figure in the paperface depth direction in FIG. 4.

Here, the vacuum chamber 11a (11) is a vacuum chamber that is used to form an electroconductive layer.

The vacuum chamber 11b (11) is a vacuum chamber that is used to form a seed layer.

The vacuum chamber 11c (11) is a vacuum chamber that is used to form a dielectric layer.

In the following explanation, the vacuum chambers are discriminated by reference numerals, and members associated with each vacuum chamber are not discriminated by reference numerals.

### (Step A): Formation of Electroconductive Layer

As shown in FIG. 3A, the electroconductive layer 3 made of platinum (Pt) is formed on a main surface of the substrate 2 made of silicon (Si).

Hereinbelow, the case of directly forming an electroconductive layer on the main surface side of the substrate will be described; however, if required, before forming the electroconductive layer, the other film may be provided on the main surface side of the substrate 2.

The pressure of the internal space of the vacuum chamber 11a (11) in which a target serving as the target 21 a (21) and made of Pt is disposed is reduced by use of a vacuum pump 15.

Consequently, the internal space of the vacuum chamber 11a (11) is in a state of having a high degree of vacuum that is higher than the degree of vacuum atmosphere in which a film is formed.

After that, the vacuum pumping is continuously carried out and the vacuum atmosphere in the vacuum chamber 11 is thereby maintained.

While maintaining the vacuum atmosphere in the vacuum chamber 11, the substrate 31 on which a film is to be formed in the internal space of the vacuum chamber 11a (11) is transferred thereto through an inlet which is not shown in the figure.

Subsequently, the substrate 31 is held on the center region of the support 32 so that the main surface side of the substrate 31 faces the sputtering surface of the target 21.

The temperature-controlled cooling medium circulates in the cooling unit 38 in advance.

Next, in a step of forming an electroconductive layer, while the substrate 31 is maintained in a film deposition temperature, an Ar gas serving as a sputtering gas is introduced into the inside of the vacuum chamber 11 from the sputtering gas introduction unit 14, an alternating voltage is applied from the sputtering power source 13 to the cathode electrode 22, and Pt target is thereby sputtered.

Consequently, the Pt electroconductive layer 3 is formed on the main surface side of the substrate 31.

### (Step B): Formation of Seed Layer

As shown in FIG. 3B, the seed layer 4 is formed so as to coat the electroconductive layer 3.

By use of a sputtering method, An oxidative product made of a compound including strontium (Sr), ruthenium (Ru), and oxygen (O) is formed as the seed layer 4.

An SRO target that is made of an oxidative product including Sr, Ru, and O and serves as the target 21 is disposed in the vacuum chamber 11b (11), the pressure of the internal space of the vacuum chamber is previously reduced by the vacuum pump 15, and in advance, the internal space of the vacuum chamber is in a vacuum state of having a high degree of vacuum that is higher than the degree of vacuum atmosphere in which a film is formed.

While maintaining the vacuum atmosphere in the vacuum chamber 11b (11), the substrate 31 on which the Pt electroconductive layer 3 is provided in advance is transferred from the vacuum chamber 11a (11) to the internal space of the vacuum chamber 11b (11).

Subsequently, the substrate 31 is held on the center region of the surface of the support 32 so that the main surface of the substrate 31, that is, the Pt electroconductive layer 3 faces the sputtering surface of the SRO target 21.

After that, while maintaining the substrate 31 at a film deposition temperature, Ar gas and oxygen gas serving as a sputtering gas are introduced into the inside of the vacuum chamber 11b (11) from the sputtering gas introduction unit 14, and the SRO target is sputtered by applying an alternating voltage to the cathode electrode 22 from the sputtering power source 13.

Consequently, the seed layer 4 made of SRO is formed on the Pt electroconductive layer 3 located on the main surface side of the substrate 31.

Particularly, in the case of forming the seed layer 4, the substrate temperature in the film formation time is controlled based on a predetermined temperature profile as necessary.

A constatnt temperature may be maintained from the start of film formation to completion of the film formation.

For example, the temperature at the start of film formation may be determined to be higher than that of the completion of the film formation.

### (Step C): Formation of Dielectric Layer

As shown in FIG. 3C, the dielectric layer 5 is formed so as to coat the seed layer 4.

In the step C, a PZT film serving as the dielectric layer 5 is formed by a sputtering method.

Here, in the step C, the substrate temperature Td when forming the dielectric layer 5 is 560°C≤Td≤720°C.

A PZT target serving as the target 21 is disposed in the vacuum chamber 11c (11), the pressure of the internal space of the vacuum chamber is reduced by the vacuum pump 15, and the internal space of the vacuum chamber is thereby in a vacuum state of having a high degree of vacuum that is higher than the degree of vacuum atmosphere in which a film is formed.

While maintaining the vacuum atmosphere in the vacuum chamber 11c (11), the substrate 31 on which the Pt electroconductive layer 3 and the seed layer 4 are provided in advance is transferred from the vacuum chamber 11b (11) to the internal space of the vacuum chamber 11c (11).

Subsequently, the substrate 31 is held on the center region of the surface of the support 32 so that the main surface of the substrate 31, that is, the seed layer 4 faces the sputtering surface of the PZT target 21.

Next, the substrate 31 is maintained in a film deposition temperature, an Ar gas and an oxygen gas which serve as a sputtering gas are introduced from the sputtering gas introduction unit 14 to the vacuum chamber 11b (11), an alternating voltage is applied from the sputtering power supply 13 to the cathode electrode 22, and the PZT target is thereby sputtered.

Accordingly, the dielectric layer 5 formed of the PZT film having the perovskite structure is formed on the seed layer 4 located on the main surface side of the substrate 31.

The substrate temperature Td when forming the dielectric layer 5 is determined to be in the range of 560°C≤Td≤720°C.

In the case where the substrate temperature Td is lower than 560°C, growth of the crystallite does not sufficiently proceed.

In the case where the substrate temperature Td is higher than 720°C, it is difficult to limit the generation of a pyrochlore phase.

Accordingly, as a result of determining the substrate temperature Td to be in the range of 560°C≤Td≤720°C, formation of a pyrochlore phase is limited, and it is possible to form the dielectric layer 5 having a high degree of crystallinity.

Particularly, in the case of forming the dielectric layer 5, the substrate temperature in the film formation time is controlled based on a predetermined temperature profile as necessary.

A constant temperature may be maintained from the start of film formation to completion of the film formation.

For example, the temperature at the start of film formation may be determined to be higher than that of the completion of the film formation.

As described hereinbelow, as compared with a conventional layered structure in which a seed layer is not provided (electroconductive layer/a dielectric layer), it is possible to limit the formation of a pyrochlore phase by employing a SRO film as the seed layer 4.

After the PZT thin film having a predetermined film thickness is formed on the substrate 31, the application of voltage from the sputtering power source 13 to the cathode electrode 22 is stopped, and the introduction of the sputtering gas from the sputtering gas introduction unit 14 into the inside of the vacuum chamber 11c (11) is stopped.

The supply of the electrical current from the heating power source 17 to the heat generation member 33 is stopped, the heat generation member 33 is cooled down, and the temperature of the substrate 31 becomes lower than the film deposition temperature.

For example, in the vacuum chamber 11c (11), the temperature of the heat generation member 33 is reduced to be lower than or equal to 400°C, and the temperature is maintained.

While maintaining the vacuum atmosphere in the vacuum chamber 11, the film-formed substrate 31 on which the multi-layered film is formed by stacking the three layers (the electroconductive layer, the seed layer, and the dielectric layer) in order is discharged to the outside of the vacuum chamber 11 through an outlet which is not shown in the figure.

Particularly, a transfer robot which is not shown in the figure is preferably used to transfer the aforementioned substrate, that is, transfer the substrate from the outside to the vacuum chamber 11a (11), transfer the substrate between the vacuum chambers, transfer the substrate from the vacuum chamber 11c (11) to the outside.

In the above manner, the multi-layered film 1 having the structure shown in FIG. 1 is manufactured.

In the multi-layered film 1, the dielectric layer 5 does not include a pyrochlore phase but has a high degree of crystallinity.

Consequently, the multi-layered film 1 realizes, for example, both high piezoelectricity and high voltage resistance, and has excellent characteristics.

The above-described multi-layered film 1 is preferably used in, for example, a piezo element or the like.

### (Experimental Example)

Hereinbelow, examples of experiment will be described which are carried out in order to check the effect of the above-described invention.

PZT films (dielectric layer) are formed with or without a seed layer, and the characteristics thereof are evaluated.

### (Experimental Example 1)

In this example, a multi-layered film was formed by stacking an electroconductive layer formed of a Pt film, a seed layer formed of an SrRuO₃ (SRO) film, and a dielectric layer formed of a PZT film in order.

As the substrate, a silicon (Si) wafer having a diameter of eight inches was used.

Here, a Si wafer was used which has a main surface side on which a thermal oxidation film (SiO₂ film), a Ti film functioning as an adhesion layer (thickness of 20 nm), and a Pt film functioning as a lower electrode layer (thickness of 100 nm) are layered in order in advance.

As a sputtering apparatus, a flat-plate magnetron sputtering apparatus (SME-200) having the configuration shown in FIG. 4 was used.

As a sputtering power source, a high-frequency power source (frequency of 13.56 MHz) was used.

The conditions of forming the seed layer formed of the SrRuO₃ film were determined as follows.

As a target, an SrRuO₃ target having a diameter of 300 mm and a thickness of 5 mm was used.

A sputtering power was 0.7 (kW), a sputtering pressure was 0.4 (Pa), and a substrate temperature was 530°C to 740°C.

The film thickness of the seed layer was 100 (nm).

The conditions of forming the dielectric layer formed of the PZT film were determined as follows.

As a target, a PZT target having a diameter of 300 mm and a thickness of 5 mm was used.

A sputtering power was 2.5 (kW), a sputtering pressure was 0.5 (Pa), and a substrate temperature was 720°C.

The film thickness of the dielectric layer was 2.0 (µm).

The sample of the experimental example 1 which is manufactured under the aforementioned conditions was referred to as Sample 1.

### (Experimental Example 2)

In this example, a multi-layered film was formed by forming a PZT film on a Pt thin film on a substrate without providing a seed layer.

A PZT film is formed under the substrate temperature condition of 585°C.

The conditions of forming the films other than the dielectric layer formed of the PZT film are the same as that of the experimental example 1.

The sample of the experimental example 2 which is manufactured under the aforementioned conditions was referred to as Sample 2.

### (Experimental Example 3)

In this example, a PZT film was formed on a Pt thin film of a Si substrate without forming a seed layer at a substrate temperature of 625°C, and a multi-layered film is thereby formed.

The conditions of forming the films other than the PZT film are the same as that of the aforementioned Sample 1.

The sample of the experimental example 3 which is manufactured under the aforementioned conditions was referred to as Sample 3.

### (Experimental Example 4)

In this example, a PZT film was formed on a Pt thin film of a Si substrate without forming a seed layer at a substrate temperature of 665°C, and a multi-layered film is thereby formed.

The conditions of forming the films other than the PZT film are the same as that of the aforementioned Sample 1.

The sample of the experimental example 4 which is manufactured under the aforementioned conditions was referred to as Sample 4.

The crystal structures of the PZT films of Samples 1 to 4 which are manufactured in the experimental examples 1 to 4, respectively, were analyzed by use of an X-ray diffraction method.

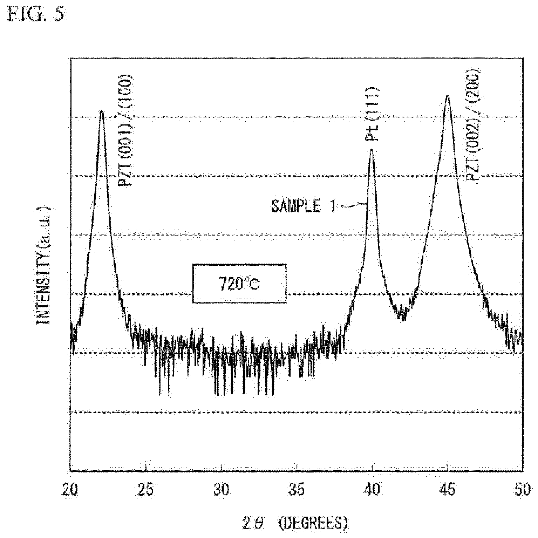

FIG. 5 shows an X-ray chart representing Sample 1 (seed layer: SrRuO₃ film).

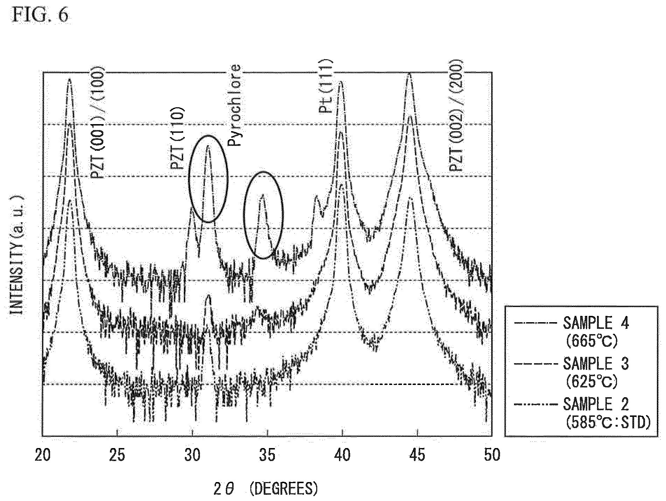

Additionally, FIG. 6 shows an X-ray chart representing Samples 2 to 4 (absence of a seed layer).

In Sample 1, the PZT films were formed in the case where a substrate temperature when forming a film varies in the range of 530°C to 740°C, and the crystal structure was analyzed for each of the PZT films which are formed at various substrate temperatures.

The PZT film is formed without forming the seed layer in Samples 2 to 4, and a peak due to a pyrochlore phase (two peaks surrounded by ellipses in FIG. 6) of Sample 4 in which the film deposition temperature is 665°C was observed from FIG. 6.

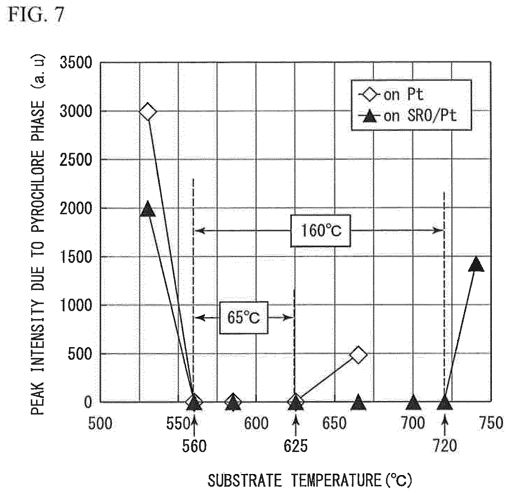

FIG. 7 is a chart showing the relationship between a substrate temperature and peak intensity due to a pyrochlore phase.

It was observed from FIG. 7 that, in Sample 1 in which the seed layer made of an SrRuO₃ film is formed, the PZT film has a pyrochlore phase serving as a different phase in the case where the substrate temperature is 740°C.

In the case of the other substrate temperatures (560°C to 720°C), a pyrochlore phase is not observed.

That is, it is apparent that, as a result of adopting the configuration using an SrRuO₃ film as a seed layer, a PZT film that does not include a pyrochlore phase is obtained in the range of 560°C≤Td≤720°C.

In the PZT film that is formed on the seed layer formed of the SrRuO₃ film, a pyrochlore phase serving as a different phase was not observed when a boundary face is initially formed.

The reason is believed to be that, since SrRuO₃ (SRO) has the coefficient of thermal expansion greater than that of the PZT, the PZT film receives a compression stress in a cooling process, and as a result, the PZT film is oriented in the c-axis.

Because of this, it was determined that, as a result of using a SrRuO₃ film as a seed layer, the PZT film can be formed at a temperature in the range of, for example, 560°C≤Td≤720°C (substrate temperature), which has a perovskite phase (that forms a crystal structure as a main component) in which a pyrochlore phase serving as a different phase is absent (which is extremely limited to be lower than the back ground in the X-ray chart).

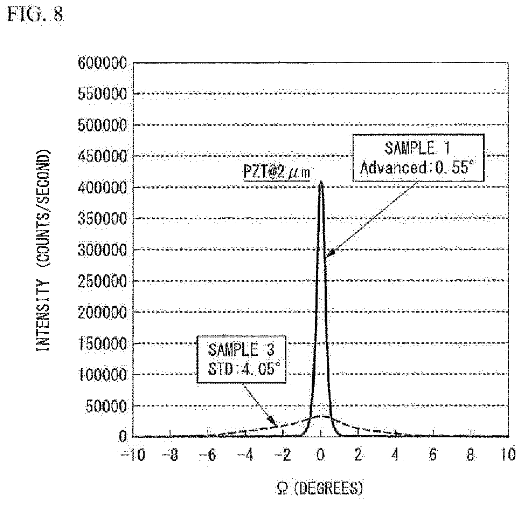

FIG. 8 is an X-ray chart showing crystallinities of the PZT films of Sample 1 (solid line) and Sample 3 (dotted line).

From Sample 1, it was observed that, even in the case of using poly PZT, a half-value width of a (100) rocking curve is 0.55 degrees, and it has an extremely higher degree of crystallinity than that of Sample 3 (a half-value width of 4.05 degrees).

That is, as described above, in the case where a crystallite grows well, the peak thereof has a sharp shape; in the case where a crystallite is small, the width of the peak becomes broader.

In Sample 3, a pyrochlore phase is prevented from being generated; however, a half-value width of the peak becomes wider, such as 4.05 degrees, and the crystallite can be said to be small.

From Sample 1, it was observed that the crystallite largely grows and has an extremely higher degree of crystallinity than that of Sample 3.

Particularly, regarding Sample 1, half-value widths (FWHM) of (100) rocking curves at the nine points on the entire area of the 8-inch wafer were measured.

As a result, it was observed that the half-value widths (FWHM) at the nine points are in the range of 0.52 to 0.59.

Accordingly, it was determined that, in the compound forming the dielectric layer manufactured by the manufacturing conditions of Sample 1, the half-value width (FWHM) of the X-ray diffraction peak due to the (100) of Pb(Zr, Ti)O₃ can be less than or equal to 1 degree.

It was determined from the above results that it is possible to form the PZT film that does not include a pyrochlore phase but has a high degree of crystallinity by forming a PZT film on the seed layer made of an SrRuO₃ (SRO) film at a temperature in the range of 560°C≤Td≤720°C.

While preferred embodiments of the invention have been described and illustrated above, the invention is not limited to the embodiments.

Various modifications may be made without departing from the scope of the invention.

### Industrial Applicability

The invention is widely applicable to a method of manufacturing a multi-layered film, and a multi-layered film.

### DESCRIPTION OF REFERENCE NUMERAL

- 1: multi-layered film
- 2: substrate
- 3: electroconductive layer
- 4: seed layer
- 5: dielectric layer
- 10: film formation apparatus
- 11: vacuum chamber
- 13: sputtering power supply
- 14: sputtering gas introduction unit
- 18: temperature controller
- 21: target
- 31: substrate
- 32: support
- 34: adhesion-preventing plate (first adhesion-preventing plate)

## Claims

1. A method of manufacturing a multi-layered film, comprising:
forming an electroconductive layer on a substrate;
forming a seed layer by compound including strontium (Sr), ruthenium (Ru), and oxygen (O) so as to coat the electroconductive layer by a sputtering method; and
forming a dielectric layer so as to coat the seed layer so that, where a substrate temperature is defined by Td (dielectric) when the dielectric layer is formed, 560°C≤Td≤720°C is satisfied.

2. The method of manufacturing a multi-layered film according to claim 1, wherein
when the dielectric layer is formed, a compound including lead (Pb), zirconia (Zr), titanium (Ti), and oxygen (O) is formed as the dielectric layer by a sputtering method.

3. A multi-layered film comprising an electroconductive layer made of platinum (Pt), a seed layer, and a dielectric layer, which are at least sequentially disposed on a main surface of a substrate made of silicon, wherein
the seed layer is made of a compound including strontium (Sr), ruthenium (Ru), and oxygen (O),
the dielectric layer is made of a compound including lead (Pb), zirconia (Zr), titanium (Ti), and oxygen (O), and
the compound that forms the dielectric layer does not have an X-ray diffraction peak due to a pyrochlore phase.

4. The multi-layered film according to claim 3, wherein
in the compound that forms the dielectric layer, a half-value width (FWHM) of an X-ray diffraction peak due to (100) of Pb(Zr, Ti)O₃ is less than or equal to 1 degree.
